Europäisches Patentamt

European Patent Office

Office européen des brevets

(19)

(11) Veröffentlichungsnummer: **0 028 734**
B1

# EUROPÄISCHE PATENTSCHRIFT

(12)

(45) Veröffentlichungstag der Patentschrift:
08.08.84

(51) Int. Cl.³ **H 04 L 25/03**, H 04 L 7/02,
H 04 B 3/04

(21) Anmeldenummer: 80106426.2

(22) Anmeldetag: 22.10.80

(54) Vorrichtung in einer Signal- bzw. Datenübertragungsanlage zur Einstellung einer Entzerrerschaltung.

(30) Priorität: 09.11.79 DE 2945331

(43) Veröffentlichungstag der Anmeldung:
20.05.81 Patentblatt 81/20

(45) Bekanntmachung des Hinweises auf die Patenterteilung:
08.08.84 Patentblatt 84/32

(84) Benannte Vertragsstaaten:
AT BE CH DE FR GB IT LI LU NL SE

(56) Entgegenhaltungen:
DE - A - 1 922 641
DE - A - 2 447 539
DE - B - 2 150 579
DE - B - 2 301 315

(73) Patentinhaber: NIXDORF COMPUTER AG,
Pontanusstrasse 55, D-4790 Paderborn (DE)

(72) Erfinder: Hüllwegen, Josef, Ing. grad., Hüttenstrasse 61,
D-4791 Altenbeken (DE)

(74) Vertreter: Schaumburg, Schulz-Dörlam & Thoenes,
Mauerkircherstrasse 31 Postfach 86 07 48,
D-8000 München 86 (DE)

## Beschreibung

Die Erfindung betrifft eine Vorrichtung nach dem Oberbegriff des Patentanspruchs 1.

Eine solche Vorrichtung ist aus der DE-B2-2 150 579 bekannt. Sie dient zur Kompensation von Abweichungen des Amplituden- und Phasenganges eines Übertragungsweges. Die während der Datenübertragung aufgetretenen Laufzeit- und/oder Dämpfungsverzerrungen werden auf diese Weise aufgehoben. Die optimale Einstellung solcher Entzerrervorrichtungen ändert sich abhängig von der Art der übertragenen Signale und der Art bzw. dem Ausmaß der jeweiligen Verzerrungen, die durch unterschiedliche Übertragungskanäle hervorgerufen werden können.

Die bekannte Vorrichtung arbeitet auf der Grundlage eines Vergleichs des Ausgangssignals der Entzerrerschaltung mit einem vorgegebenen Bezugssignal. Das Ausgangssignal der Entzerrerschaltung erzeugt außerdem eine Impulsfolge, aus der durch Zählung während eines vorgegebenen Zeitabschnitts Steuersignale abgeleitet werden, die zur Steuerung der Integration der aus dem Vergleich erhaltenen Fehlersignale dienen. Die integrierten Fehlersignale werden dann zur Einstellung der Entzerrerschaltung ausgenutzt.

Ein solches Prinzip der Ableitung von Einstellungssignalen für die Entzerrerschaltung auf der Grundlage eines Vergleichs mit einem vorgegebenen Bezugssignal führt zu einer insgesamt sehr aufwendigen Schaltung, die zur ordnungsgemäßen Arbeitsweise eine Abschaltung des Übertragungsweges und den Einsatz einer Reserveleitung während des Einstellvorgangs erfordert.

Es ist Aufgabe der Erfindung, eine Vorrichtung zur Einstellung einer Entzerrerschaltung anzugeben, die nach einem anderen Prinzip arbeitet, welches eine weniger aufwendige und komplizierte Schaltungstechnik erfordert und. keinen Bezugssignalgenerator benötigt.

Diese Aufgabe wird erfindungsgemäß durch die Merkmale des Patentanspruchs 1 gelöst. Vorteilhafte Weiterbildungen sind Gegenstand der Unteransprüche.

Bei einer Vorrichtung nach der Erfindung sind ein Haupt- und ein Hilfsentzerrer vorgesehen, die mit ein und demselben, auf dem Übertragungskanal verzerrten Signal angesteuert werden. Durch das Prinzip der periodisch veränderbaren Einstellung des Hilfsentzerrers in Verbindung mit der Abtast- und Halteschaltung, die die momentane Einstellung des Hilfsentzerrers bei Auftreten des Detektorsignals auf den Hauptentzerrer überträgt, wird ein besonderer Bezugssignalgenerator überflüssig, der bei der bekannten Vorrichtung zur Erzeugung des Bezugssignals benötigt wird. Auf diese Weise ergibt sich eine Vorrichtung, die lediglich mit dem auf dem Übertragungskanal verzerrten Signal angesteuert wird und am Hauptentzerrer das aufbereitete Signal abgibt, ohne daß komplizierte Ver gleichsvorgänge unter Verwendung eines separaten Bezugssignalgenerators durchgeführt werden müssen.

Die richtige Einstellung einer Entzerrerschaltung zeichnet sich beispielsweise dadurch aus, daß ihr Ausgangssignal bei dieser Einstellung einen Extremwert aufweist. Die zu diesem Extremwert führende Einstellung sei abhängig von bestimmten Faktoren veränderlich, so daß eine ständige Nachstellung erforderlich ist. Es sei darüber hinaus möglich, daß das Ausgangssignal der Entzerrerschaltung in deren gesamtem Einstellbereich mehrere, sich in der absoluten Höhe unterscheidende Extremwerte aufweist, von denen das absolute Maximum der optimalen Einstellung entspräche. Eine Einrichtung, bei der dieses Problem beispielsweise auftritt, ist ein Autoradio, das immer auf den am besten zu empfangenden Verkehrsfunksender eingestellt sein soll. Auf ein solches Autoradio übertragen bedeutet die erfindungsgemäße Lösung, daß ein zweiter Empfangsteil vorgesehen wird und periodisch durch den gesamten Empfangsfrequenzbereich abgestimmt wird. Von den Empfangssignalen werden nur diejenigen mit einer Verkehrsfunkkennung ausgewertet. Befindet sich das mit diesem Autoradio ausgestattete Fahrzeug im Bereich mehrerer Verkehrsfunksender, dann wird das Ausgangssignal des zusätzlichen Empfangsteils während einer Abstimmperiode mehrere Maxima aufweisen, deren absoluter Wert in der Regel unterschiedlich sein wird. Der nachgeschaltete Detektor kann so ausgebildet sein, daß er während der ersten Abstimmperiode bei jedem Maximum ein Detektorsignal erzeugt, dessen Absolutwert größer als der des vorangegangenen Maximums ist. Der Detektor speichert dann dieses größte Maximum und erzeugt bei den folgenden Perioden nur noch bei diesem größten Maximum sein Detektorsignal. Dadurch, daß die Einstellung bzw. der Abstimmzustand des zusätzlichen oder Hilfs-Empfangsteils zum Zeitpunkt des Auftretens des Detektorsignals auf den Haupt-Empfangsteil übertragen wird, wird das Autoradio automatisch auf den am stärksten einfallenden Verkehrsfunksender abgestimmt. Gerät das Fahrzeug langsam aus dem Bereich dieses Senders heraus, dann wird auch der absolute Wert des Maximums des Ausgangssignals des Hilfs-Empfangsteils immer kleiner, bis schließlich ein anderer Sender stärker einfällt und die Abstimmung auf diesen Sender erfolgt.

Es ist vorteilhaft, wenn die Entzerrerschaltungen mittels eines vorzugsweise elektrischen Stellsignals einstellbar sind, so daß die Hilfsentzerrerschaltung von einer Wobbeleinrichtung mit einem sich periodisch verändernden Stellsignal und die Haupt-Entzerrerschaltung vom Ausgangssignal der Abtast- und Halteeinrichtung beaufschlagt wird.

Eine bevorzugte Anwendung der erfindungsgemäßen Vorrichtung liegt in der Einstellung des Entzerrers in einer Signal- bzw. Datenübertragungsanlage, der mit einem auf einem Übertragungsweg verzerrten Signal gespeist wird. Wenn es sich bei dem übertragenen Signal um ein solches handelt, das Signalkomponenten unterschiedlicher Frequenz enthält und im unverzerrten Zustand periodisch Nulldurchgänge aufweist, dann werden die bei der Übertragung auftretenden und die einzelnen Frequenzkomponenten unterschiedlich beeinflussenden Laufzeitverzerrungen zu einem Signalzustand führen, bei dem die Nulldurchgänge der einzelnen Signalkomponenten gegeneinander verschoben sind, so daß sich kein Nulldurchgang des Gesamtsignals mehr feststellen läßt. Die Güte der Entzerrereinstellung läßt sich dann daran messen, wie scharf der Nulldurchgang seines Ausgangssignals ist. Um diese Güte meßtechnisch zu erfassen, ist die Weiterbildung gemäß Anspruch 3 vorgesehen.

Das bei einer Datenübertragungsanlage empfangene Signal ist in der Regel ein moduliertes Signal, dessen Modulation die übertragenen Daten enthält, aus denen ein mit den Daten phasenstarres Datentaktsignal abgeleitet werden kann. Ebenso wird aus dem vom Hilfs-Entzerrer gelieferten Signal ein phasenstarres Hilfs-Taktsignal abgeleitet. Zur Öffnung der Torschaltung während des Zeitfensters dient dann die Weiterbildung gemäß Anspruch 4. Das Hilfstaktsignal wird in einer der Synchroneinrichtung folgenden Signalverzögerungsschaltung in die Nähe des Nulldurchgangs des modulierten Eingangssignals verzögert. An den Ausgang der Signalverzögerungsschaltung kann dann ein Impulsgeber angeschlossen sein, der aus dem verzögerten Hilfs-Taktsignal einen symmetrisch zum Nulldurchgang des Eingangssignals liegenden und das Zeitfenster bestimmenden Impuls an die Torschaltung abgibt.

Die Ausgestaltung der Erfindung gemäß Anspruch 5 ermöglicht eine Einstellung abhängig davon, ob der Extremwertdetektor bei jedem Extremwert seines Eingangssignals ein Detektorsignal abgeben soll oder nur beim absolut höchsten oder niedrigsten Extremwert. Entsprechend kann die Zeitkonstante der RC-Schaltung bemessen werden.

Die Entzerrerschaltungen können gemäß Anspruch 6 einen manuell oder abhängig vom Eingangssignal automatisch umschaltbaren Grobbereichswähler aufweisen, der einen von mehreren Grobbereichen vorwählt, innerhalb dessen dann die erfindungsgemäße Einstellung erfolgt.

Die Erfindung wird im folgenden anhand von Ausführungsbeispielen unter Bezug auf die Zeichnungen näher erläutert. Es zeigt

Fig. 1 ein Übersichtsblockschaltbild eines Entzerrers mit erfindungsgemäßer Einstellvorrichtung und nachgeschalteter Phasensynchronisiereinrichtung,

Fig. 2 ein detailliertes Blockschaltbild des Entzerrers mit der Einstellvorrichtung,

Fig. 3 ein schematisches Schaltbild der Anordnung nach Fig. 2 und

Fig. 4 Signalverläufe an verschiedenen Punkten in Fig. 3.

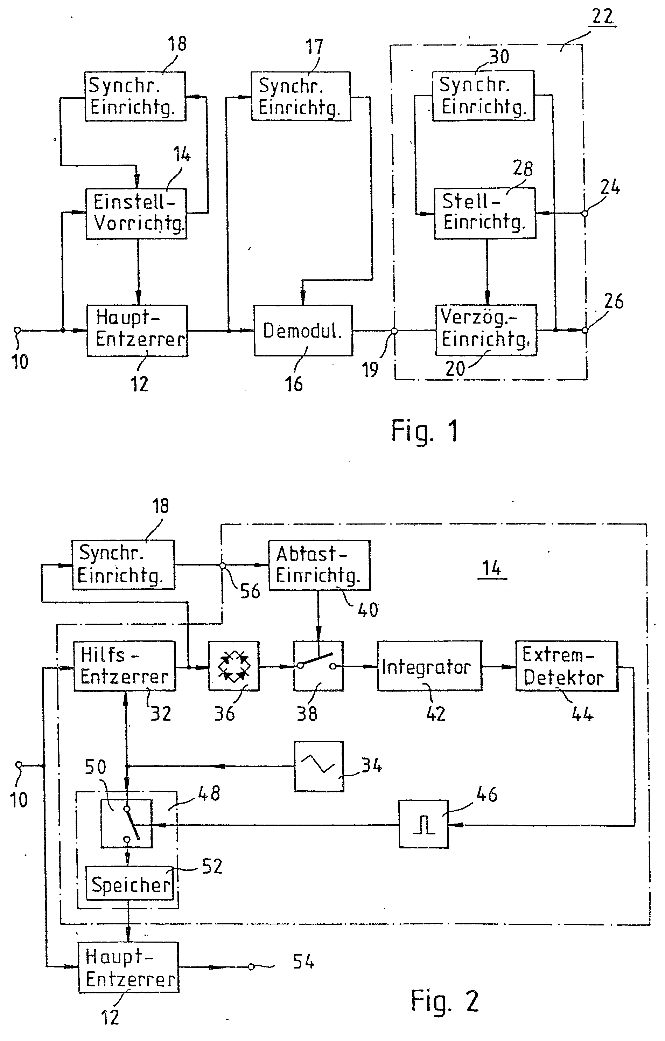

Fig. 1 zeigt einen Teil der Empfangsstelle eines Datenübertragungssystems.

An einen Eingangsanschluß 10 wird ein Eingangssignal in Form eines modulierten und auf dem Übertragungsweg verzerrten Signals angelegt. Dieses Eingangsignal gelangt sowohl auf einen Hauptentzerrer 12 als auch auf eine Einstellvorrichtung 14, die einen dem Hauptentzerrer 12 gleichenden Hilfsentzerrer enthält. Die Einstellvorrichtung 14 stellt den Hauptentzerrer 12 automatisch so ein, daß sich eine optimale Entzerrung des verzerrten Eingangssignals ergibt. Dieses entzerrte Signal gelangt auf einen Demodulator 16. Am Ausgang des Demodulators steht das Datensignal an, das die übertragenen Daten und einen mit ihnen phasenstarr gekoppelten Datentakt enthält. Das Ausgangssignal des Hauptentzerrers wird zur Erzeugung des Datensignals einer Synchroneinrichtung 17 zugeführt. Eine weitere Synchroneinrichtung 18 erzeugt aus dem Ausgangssignal des Hilfs-Entzerrers 32 (Fig. 2) in später noch näher beschriebener Weise ein für die Einstellvorrichtung 14 erforderliches Hilfs-Taktsignal. Die Verzögerungseinrichtung 20 ist Teil einer Phasensynchronisiervorrichtung 22 und bewirkt eine Phasenverschiebung des Datensignals zur Anpassung an das Taktraster eines örtlichen Empfängertakts, der in einen Taktanschluß 24 eingegeben wird. Das am Ausgang 26 zur Verfügung stehende Datensignal kann dann mit Hilfe des Empfängertakts weiter verarbeitet werden. Die Synchronisierung zwischen den Daten des Datensignals und dem Empfängertakt erfolgt mit Hilfe einer die Verzögerungszeit der Verzögerungseinrichtung 20 einstellenden Stelleinrichtung 28, die einen Phasenvergleicher enthält. Aus dem Ausgangssignal der Verzögerungseinrichtung 20 wird mit Hilfe einer Synchroneinrichtung 30 der Datentakt rückgewonnen, dessen Phase im Phasenvergleicher der Stelleinrichtung 28 mit derjenigen des Empfängertakts an 24 verglichen wird. Die Verzögerungseinrichtung wird abhängig von dieser Phasendifferenz eingestellt.

Anhand der Fig. 2 bis 4 sei zunächst die Einstellvorrichtung 14 im einzelnen erläutert. Fig. 2 zeigt ein Blockschaltbild dieser Einstellvorrichtung.

Wie bereits erwähnt, enthält die Einstellvorrichtung 14 einen Hilfsentzerrer 32, der dem Hauptentzerrer 12 völlig gleicht. Beide Entzerrer sind mit Hilfe eines elektrischen Stellsignals einstellbar, so daß man die Entzerrerwirkung verändern kann. Es kann sich beispielsweise um Laufzeitentzerrer handeln, deren Zeitkonstanten durch das Stellsignal beeinflußt werden. Bei gleicher Einstellung von Hauptentzerrer und Hilfsentzerrer ist deren Wirkung identisch. Der Steuereingang des Hilfsentzerrers 32 ist mit dem Ausgang einer Wobbeleinrichtung 34 verbunden, die beispielsweise ein Sägezahn-Stellsignal liefert, dessen Amplitude so bemessen ist, daß der gesamte Stellbereich des Hilfsentzerrers 32 während einer Periode des Stellsignals durchfahren wird. Das Ausgangssignal des Hilfsentzerrers 32 gelangt auf einen Doppelweggleichrichter 36, dessen Ausgang mit dem Eingang einer Torschaltung 38 verbunden ist. Die Torschaltung 38 stellt abhängig vom Steuersignal von einer Abtasteinrichtung 40 eine Verbindung zwischen dem Ausgang des Doppelweggleichrichters 36 und einem Integrator 42 her. Dem Integrator 42 ist ein Extremwertdetektor 44 nachgeschaltet, an den wiederum ein Impulsformer 46 angeschlossen ist. Der Impulsformer 46 erzeugt ein Steuersignal für eine weitere Torschaltung 50, die Teil einer Abtast- und Halteschaltung 48 ist. Diese Abtast- und Halteschaltung enthält ferner einen Speicher 52, der bei geschlossener Torschaltung 50 den momentanen Wert des Stellsignals von der Wobbeleinrichtung 34 speichert und an den Steuereingang des Hauptentzerrers 12 anlegt. Die Einstellung des Hauptentzerrers 12 hängt somit von dem im Speicher 52 gespeicherten Stellwert ab, der sich seinerseits danach bestimmt, zu welchem Zeitpunkt während einer Periode des Stellsignals der Impulsformer 46 das Steuersignal an die Torschaltung 50 liefert. Wenn der Speicher 52 einmal einen Stellwert übernommen hat, dann hält er ihn so lange, bis bei erneutem Schließen der Torschaltung 50 ein neuer Stellwert vorgegeben wird.

Die Einstellung des Hilfsentzerrers 32 wird bei der erfindungsgemäßen Vorrichtung ständig geändert, wobei periodisch der gesamte Stellbereich durchfahren wird. Demzufolge ändert sich auch das Ausgangssignal des Hilfsentzerrers 32, das während dessen Verstellung mal besser und mal schlechter entzerrt ist. Der die Elememte 36 bis 46 enthaltende Detektor ermittelt den Zeitpunkt, zu dem das Ausgangssignal des Hilfsentzerrers 32 am besten entzerrt ist. Zu diesem Zeitpunkt gibt der Impulsformer 46 sein Steuersignal an die Abtast- und Halteschaltung 48, die dann den in diesem Moment anliegenden Stellwert des Stellsignals übernimmt und auf den Hauptentzerrer 12 überträgt. Ändert sich nun im Laufe der Zeit die Entzerrereinstellung, bei der die Entzerrung des Eingangssignals optimal ist, dann wird auch der Hauptentzerrer in der beschriebenen Weise nachgestellt, da die optimale Entzerrereinstellung mit Hilfe des Hilfsentzerrers 32 ständig überprüft wird. Eine andere Entzerrereinstellung kann beispielsweise dann erforderlich werden, wenn sich die Verzerrungen des Eingangssignals ändern, weil dieses beispielsweise nun über einen anderen Übertragungsweg von einem anderen Sender stammt. Aber auch andere Faktoren können einen Einfluß darauf haben, welche Entzerrereinstellung jeweils optimal ist.

Im vorliegenden Fall wird ein spezielles, nachfolgend erläutertes Kriterium für die Feststellung herangezogen, wann die Einstellung des Hilfsentzerrers 32 optimal ist. Es muß nicht betont werden, daß der Aufbau des Detektors im einzelnen von dem jeweiligen Kriterium abhängt und im vorliegenden Fall an das verwendete Kriterium angepaßt ist. Wenn es sich bei den hier anhand von Entzerrern beschriebenen Signalverarbeitungsschaltungen beispielsweise um solche handelt, deren Ausgangssignal bei optimaler Einstellung einen Extremwert besitzt, dann könnte der Ausgang der Hilfssignalverarbeitungsschaltung direkt mit dem Extremwertdetektor verbunden werden. Die Elemente 36 bis 42 wären dann überflüssig.

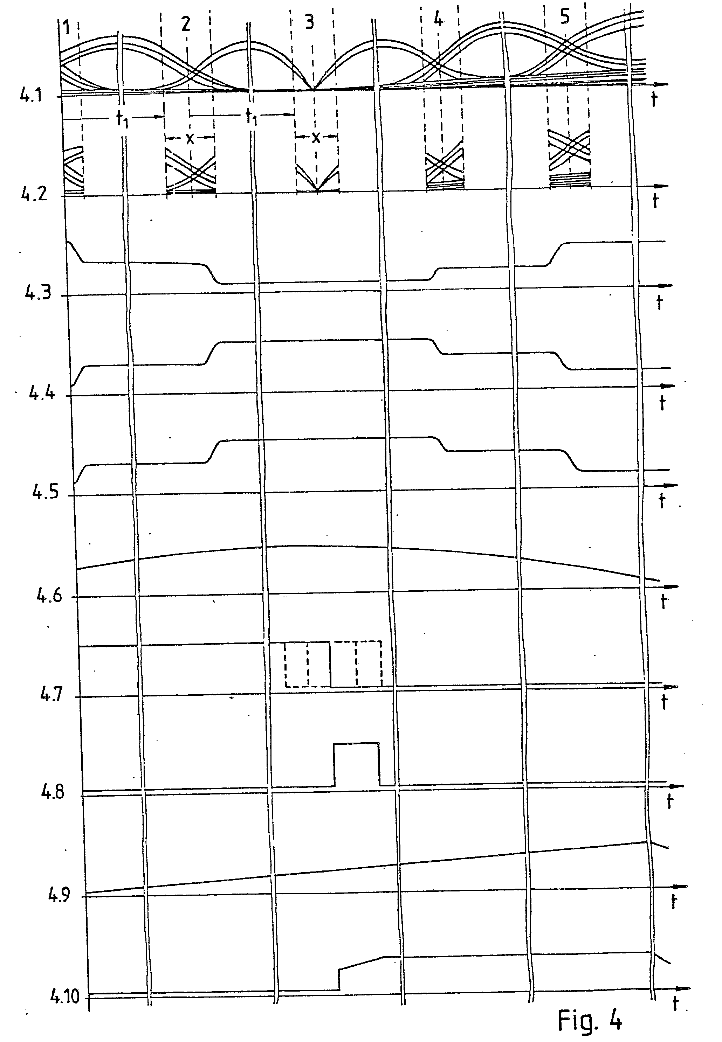

Das im vorliegenden Fall ausgenutzte Kriterium sei anhand der Fig. 4.1 und 4.2 erläutert. Das am Eingangsanschluß 10 anstehende modulierte Eingangssignal setzt sich aus verschiedenen Signalkomponenten zusammen und besitzt im unverzerrten Zustand einen ausgeprägten Nullduchgang, d. h., daß die Nulldurchgänge der einzelnen Signalkomponenten unterschiedlicher Frequenz nahe bei der gleichen Phase des Übertragungs- oder Datentaktes erfolgen. Aufgabe des Entzerrers ist es, die Dämpfungs- oder Laufzeiteigenschaften für unterschiedliche Frequenzen der Übertragungsleitung so auszugleichen, daß die im verzerrten Signal gegeneinander phasenverschobenen Nulldurchgänge der Signale wieder möglichst nahe zur gleichen Phase des Datentakts liegen. Fig. 4.1 zeigt bei der Einstellung 3 die erwünschte optimale Entzerrung. Bei den Einstellungen 1, 2, 4 und 5 ist die Entzerrung jeweils immer schlechter. In Fig.4.2 ist entsprechend den fünf Einstellzuständen von Fig.4.1 jeweils ein bestimmter Zeitausschnitt des Signals am Ausgang des Doppelweggleichrichters 36 herausgegriffen. Es handelt sich um einen Zeitausschnitt bzw. ein Zeitfenster x, das symmetrisch zum Nulldurchgang des unverzerrten Signals liegt. Man erkennt aus einem Vergleich der Signalausschnitte in Fig. 4.2, daß das Integral über diesen Signalausschnitt umso kleiner sein wird, je näher die Einstellung des Hilfsentzerrers 32 der optimalen Einstellung kommt. Mit Hilfe der Doppelweggleichrichtung und der Integration über ein bestimmtes Zeitfenster kann daher das Kriterium des scharfen Nulldurchgangs in das Kriterium eines Minimums umgewandelt werden. Daraus ergibt sich auch schon, daß die Abtasteinrichtung 40 die Torschaltung 38 so steuern muß, daß der Integrator 42 während der Periode des Eingangssignals gerade für die Dauer des Zeitfensters x mit dem Doppelweggleichrichter 36 verbunden sein muß.

Die Synchroneinrichtung 18 gewinnt aus dem entzerrten Signal vom Hilfsentzerrer 32 einigermaßen stabil den Hilfstakt, dessen Phasenlage ein Maß für den mittleren Nulldurchgang der einzelnen Signalkomponenten ist. Mit Hilfe dieses Hilfstaktes erzeugt die Abtasteinrichtung 40 um den Nulldurchgang herum das Zeitfenster x. Innerhalb des Zeitfensters wird ein Maß für die Bündelung der Nulldurchgänge gebildet. Da Signaldurchgänge mit verschiedenen Neigungen und Richtungen erfolgen, sowie deren Häufigkeit statisch verteilt ist, kann eine feste Grenze für den Wert nicht bestimmt werden. Auch hängt der Wert von der Lage des Fensters zu dem mittleren Nulldurchgang ab. Durch die Doppelweggleichrichtung und die nachfolgende Integration der jeweils entstehenden Teilflächen der Signalspannung über die Zeit innerhalb des Fensters entsteht ein Signalbeitrag für jedes durch Null gehende Signal, der bei Durchgang in der Mitte des Fensters halb so groß ist wie bei der Lage am Rand des Fensters. Da durch eine entsprechend lange Integrationszeit viele solche Beiträge gemittelt werden, ergibt sich ein relatives Gütemaß für die Entzerrung. Da der mittels der Synchroneinrichtung 18 abgeleitete Hilfstakt umso stabiler ist, je besser das Eingangssignal entzerrt ist, tastet sich der Abgleich an das Optimum heran.

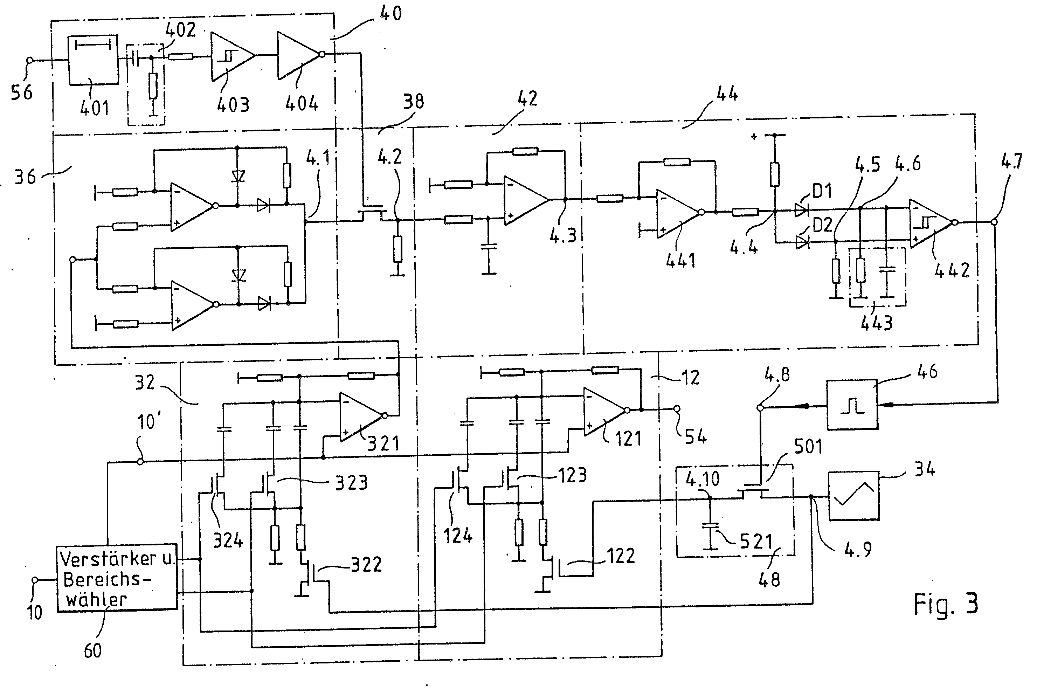

Fig. 3 zeigt einen möglichen Schaltungsaufbau der Vorrichtung von Fig. 2.

Es sei zunächst die Zeitfenstererzeugung erläutert. Die Abtastschaltung 40 enthält ein Verzögerungsglied 401, das über einen Anschluß 56 von der Synchroneinrichtung 18 (Fig. 2) die Hilfstaktimpulse erhält und diese um eine einstellbare Zeit $t_1$ verzögert. Nimmt man an, daß die Schaltflanke der Hilfstaktimpulse phasengleich mit dem mittleren Nulldurchgang des Eingangssignals ist, dann entspricht die Verzögerungszeit $t_1$ der halben Periodendauer des Eingangssignals minus der halben Breite x des gewünschten Zeitfensters (vgl. Fig. 4.1). Diese Verzögerung kann digital mit Hilfe eines Taktzählers realisiert werden. Auf diese Weise kann bei Umschaltung der Übertragungsgeschwindigkeit die Verzögerung durch gleichzeitige Umschaltung der Taktfrequenz auf einfache Weise angepaßt werden. Der verzögerte Hilfstaktimpuls gelangt in der Abtasteinrichtung 40 über ein RC-Differenzierglied 402 auf einen hysteresebehafteten Schaltverstärker 403. Am Ausgang des Schaltverstärkers 403 tritt ein nach Lage und Breite dem Zeitfenster x entsprechender Impuls auf, der über einen Inverter 404 einen die Torschaltung 38 darstellenden Feldeffekttransistor durchschaltet.

Die Entzerrer 12 und 32 sind in Fig. 3 als mit einer frequenzabhängigen Beschaltung versehene Verstärker 121 bzw. 321 dargestellt. Die Zeitkonstanten der frequenzabhängigen Beschaltung sind mit Hilfe von Feldeffekttransistoren 122, 123, 124 bzw. 322, 323 und 324 veränderbar, wobei die Feldeffekttransistoren 122 und 322 mit dem Stellwert von der Abtast- und Halteschaltung 48 bzw. dem Stellsignal von der Wobbeleinrichtung 34 beaufschlagt sind. Statt der Feldeffekttransistoren 122 und 322 können auch andere Stellglieder verwendet werden. So können die den genannten Feldeffekttransistor vorgeschalteten Widerstände z. B. als Fotowiderstände ausgeführt sein, die von Leuchtdioden bestrahlt werden. Diese Leuchtdioden müssen mit der Spannung betrieben werden, die in dem in Fig. 3 dargestellten Ausführungsbeispiel den Gates der Feldeffekttransistoren 122 bzw. 322 zugeführt wird. Funktionswichtig ist nur, daß beide Stellglieder 122 und 322 genau gleiche Regelcharakteristiken haben. Die jeweiligen anderen Feldeffekttransistoren dienen einer Grobbereichsumschaltung, die bei der dargestellten Ausführungsform von einem Verstärker und Bereichswähler 60 abhängig vom Eingangssignal am Eingangsanschluß 10 automatisch vorgenommen wird, aber auch von Hand erfolgen könnte. Der Verstärker und Bereichswähler 60 verstärkt außerdem das am Eingangsanschluß 10 anstehende Eingangssignal und liefert es an einen Anschluß 10'.

Die in Fig. 3 dargestellte Ausführungsform des Doppelweggleichrichters 36 ist für den Fachmann aus sich selbst heraus verständlich und bedarf keiner näheren Erläuterung. Gleiches gilt für den Integrator 42. Die Ausgangspannung des Integrators 42 wird minimal, wenn die beste Einstellung des Hilfs-Entzerrers 32 erreicht ist. Ein dem Integrator 42 im Extremwertdetektor 44 nachgeschalteter Inverter 441 formt dieses Minimum zu einem Maximum um. Der Ausgang des Inverters 441 ist über eine jeweilige Diode $D_1$, $D_2$ mit den beiden Eingängen eines hysteresebehafteten Differenzverstärkers 442 verbunden.

An den invertierenden Eingang des Differenzverstärkers 442 ist außerdem noch eine Verzögerungsschaltung bestehend aus der Parallelschaltung eines Kondensators und eines Widerstands angeschlossen. Diese Verzögerungsschaltung 443 bewirkt, daß jede Spannungsänderung der Ausgangsspannung des Inverters 441 sich am invertierenden Eingang des Differenzverstärkers 442 um die Zeitkonstante der Verzögerungsschaltung 443 gegenüber dem nicht-invertierenden Eingang verzögert bemerkbar macht. Daher ergibt sich am Ausgang des Differenzverstärkers 442 eine Spannungsumkehr, sobald die Ausgangsspannung des Inverters 441 ein Maximum überschreitet. Die Spannungsumkehr am Ausgang des Differenzverstärkers 442 wird mit Hilfe des Impulsformers 46, bei dem es sich um eine monostabile Kippstufe handeln kann, in einen kurzzeitigen Steuerimpuls für die Abtast- und Halteschaltung 48 umgeformt.

Die Zeitkonstante der Verzögerungsschaltung 443 hat maßgeblichen Einfluß auf die Arbeitsweise der dargestellten Schaltung. Es kann sowohl bei dem als Beispiel beschriebenen Anwendungsfall, aber auch bei anderen Anwendungsfällen der Fall auftreten, daß das Kriterium, welches die richtige Einstellung der Hilfs-Signalverarbeitungsschaltung anzeigt, innerhalb des Stellbereichs der Hilfs-Signalverarbeitungsschaltung mehrfach auftritt. Handelt es sich bei diesem Kriterium um das am Ausgang des Inverters 441 auftretende Maximum, dann können also mehrere Maxima auftreten, die sich in ihrer absoluten Höhe unterscheiden können. Liegt nun die optimale Einstellung bei dem Maximum, dessen Absolutwert der größte ist, dann kann durch entsprechende Bemessung der Zeitkonstante der Verzögerungsschaltung 443 erreicht werden, daß die Haupt-Signalverarbeitungsschaltung bzw. hier der Hauptentzerrer 12 auf dieses Optimum eingestellt wird. Die Zeitkonstante der Verzögerungsschaltung 443 muß dazu groß gegenüber der Periodendauer des Stellsignals von der Wobbeleinrichtung 34 sein, derart, daß sich der Kondensator der Verzögerungsschaltung 443 während dieser Periodendauer gerade so weit entlädt, daß im nächsten Zyklus das optimale Maximum vom Differenzverstärker 442 erneut erkannt wird, daß andere Maxima mit geringerem Absolutwert aber nicht erkannt werden, da bei ihnen die Spannung am nicht-invertierenden Eingang des Differenzverstärkers 442 immer kleiner als die im Kondensator der Verzögerungsschaltung 443 gespeichert bleibt. Die Zeitkonstante der Verzögerungsschaltung 443 darf andererseits nicht zu groß gewählt werden, da sich ja die Verhältnisse ständig ändern können und der Absolutwert des höchsten Maximums niedriger werden kann. In diesem Fall darf es natürlich nicht zu lange dauern, bis nach entsprechender Entladung des Kondensators in der Verzögerungsschaltung 443 eine erneute Spannungsumkehr am Ausgang des Differenzverstärkers 442 auftritt, die den Impulsformer 46 triggert. Um für die Bemessung der Zeitkonstante der Verzögerungsschaltung 443 einen mehr oder weniger schlechten Kompromiß zu vermeiden, könnte eine Rücksetzschaltung vorgesehen werden, die den Kondensator der Verzögerungsschaltung 443 rasch entlädt, wenn für die Dauer von einer oder zwei Perioden des Stellsignals der Wobbeleinrichtung 34 kein Steuerimpuls von dem Impulsformer 46 abgegeben wurde.

Die Wobbeleinrichtung 34 liefert eine sägezahn- oder dreieckförmige Spannung an das Gate des Feldeffekttransistors 322 im Hilfs-Entzerrer 32. Über einen als Torschaltung 50 arbeitenden Feldeffekttransistor 501 ist der Ausgang der Wobbeleinrichtung 34 während der Dauer eines Steuerimpulses vom Impulsformer 46 mit einem Speicherkondensator 521 verbunden. An den Speicherkondensator ist das Gate des Feldeffekttransistors 122 angeschlossen.

Fig. 4 zeigt für die verschiedenen Einstellungszustände 1 bis 5 die jeweiligen Signale an verschiedenen Punkten der Schaltung von Fig. 3. Zur Zuordnung der unter 4.1 bis 4.10 dargestellten Signale sind in Fig. 3 die zugehörigen Schaltungspunkte entsprechend mit 4.1 bis 4.10 bezeichnet.

Das Signal 4.3 am Ausgang des Integrators 42 steigt umso mehr an, je schlechter die Entzerrung des Eingangssignals ist. Das demgegenüber invertierte Signal 4.4 wird mit schlechter werdender Entzerrung immer kleiner. Das Signal 4.5 ist mit dem Signal 4.4 im wesentlichen identisch. Das Signal 4.6 hingegen folgt dem Signal 4.5 mit einer erheblichen Verzögerung. Wenn der Spannungswert des Signals 4.6 größer als derjenige des Signals 4.5 wird, nachdem das Verhältnis vorher umgekehrt war, tritt am Ausgang des Differenzverstärkers 442 ein Spannungssprung gemäß dem Signal 4.7 auf. Die gestrichelten Flanken in Fig.4.7 deuten den Bereich an, innerhalb dessen der Spannungssprung auftreten kann. Dieser Spannungssprung triggert die Impulsformerschaltung 46, die das Impulssignal 4.8 an das Gate des Feldeffekttransistors 501 liefert. Im Moment des Auftretens dieses Impulses übernimmt der Speicherkondensator 521 gemäß Fig. 4.10 den momentanen Signalwert des Stellsignals 4.9 von der Wobbeleinrichtung 34. Die Dauer des Impulses 4.8 ist so bemessen, daß sich einerseits der Speicherkondensator 521 voll auf den Stellwert aufladen kann und daß andererseits während dieser Aufladezeit nur eine unbeachtliche Signalwertänderung des Stellsignals 4.9 auftritt.

## Patentansprüche

1. Vorrichtung in einer Signal- bzw. Datenübertragungsanlage zur Einstellung einer an einen Übertragungsweg angeschlossenen Entzerrerschaltung (12), deren Ausgangssignal bei einer sich ändernden optimalen Einstellung eine bestimmte, mittels eines Detektors (36 bis 44) feststellbare Eigenschaft besitzt, wobei der Detektor (36 bis 44) ein Detektorsignal an eine Schaltung mit Speichereigenschaften abgibt, wenn das Ausgangssignal die bestimmte Eigenschaft besitzt, dadurch gekennzeichnet, daß eine Hilfsentzerrerschaltung (32) vorgesehen ist, mit deren Ausgangssignal der Detektor (36 bis 44) beaufschlagt ist, daß beide Entzerrerschaltungen (12, 32) parallel mit ein und demselben, auf dem Übertragungsweg verzerrten Signal gespeist werden, daß die Einstellung der Hilfsentzerrerschaltung (32) periodisch durch den gesamten Stellbereich veränderbar ist und daß eine Abtast- und Halteschaltung (48, 52) vorgesehen ist, die die momentane Einstellung der Hilfsentzerrerschaltung (32) bei Auftreten des Detektorsignals auf die Hauptentzerrerschaltung (12) überträgt und deren Einstellung bis zum nächsten Detektorsignal hält.

2. Vorrichtung nach Anspruch 1, dadurch gekennzeichnet, daß die Hilfsentzerrerschaltung (32) von einer Wobbeleinrichtung (34) mit einem sich periodisch verändernden Stellsignal und die Hauptentzerrerschaltung (12) vom Ausgangssignal der Abtast- und Halteeinrichtung (48) beaufschlagbar sind.

3. Vorrichtung nach Anspruch 2, dadurch gekennzeichnet, daß der Detektor einen Doppelweggleichrichter (36) aufweist, welcher über eine Torschaltung (38) an einen Integrator (42) und einen diesem nachgeschalteten Extremwertdetektor (44) angeschlossen ist, wobei die Torschaltung während eines symmetrisch zum Nulldurchgang des unverzerrten Eingangssignals liegenden Zeitfensters (x) durchschaltet und der Extremwertdetektor das Detektorsignal (4.7) abgibt, wenn das Ausgangssignal des Integrators während einer Periode des Stellsignals ein Minimum erreicht.

4. Vorrichtung nach Anspruch 3, dadurch gekennzeichnet, daß der Ausgang der Hilfs-Entzerrerschaltung (32) mit einer Synchroneinrichtung (18) verbunden ist, die ein in bestimmter Phasenlage zu den Nulldurchgängen des Eingangssignals liegendes Hilfs-Taktsignal erzeugt, und daß mit dem Ausgang der Synchroneinrichtung eine Signalverzögerungsschaltung (401) und mit deren Ausgang ein über ein Differenzierglied (402) hysteresebehafteter und die Torschaltung (38) steuernder Schaltverstärker (403; 404) verbunden ist.

5. Vorrichtung nach einem der Ansprüche 3 oder 4, dadurch gekennzeichnet, daß der Extremwertdetektor (44) einen hysteresebehafteten Differenzverstärker (442) aufweist, dessen beide Eingänge je über eine Diode (D₁; D₂) mit einem Signaleingang verbunden sind und dessen einer Eingang (−) ferner mit einer Verzögerungsschaltung (443) verbunden ist, deren Zeitkonstante groß im Verhältnis zur Periode der Wobbeleinrichtung (34) ist.

6. Vorrichtung nach einem der vorhergehenden Ansprüche, dadurch gekennzeichnet, daß die Entzerrerschaltungen (12; 32) einen manuell oder abhängig vom Eingangssignal automatisch umschaltbaren Grobbereichswähler aufweisen.

## Claims

1. A device within a signal or data transmitting system for adjusting an equalizing circuit (12) which is connected to a transmission path, the output signal of said equalizing circuit having a predetermined characteristic detectable by means of a detector (36 to 44) at a varying optimum adjustment, said detector (36 to 44) emitting a detector signal to a circuit having storing characteristics when said output signal is in the state of said predetermined characteristic, characterized in that there is provided an auxiliary equalizing circuit (32), said detector (36 to 44) being impinged by the output signal of said equalizing circuit, that both equalizing circuits (12, 32) are charged in parallel with one and the same signal distorted on the transmission path, that the adjustment of said auxiliary equalizing circuit (32) is periodically variable by the total range of manipulated variable, and that there is provided a scanning and holding circuit (48, 52) transmitting the instantaneous adjustment of said auxiliary equalizing circuit (32) to said primary equalizing circuit (12) when said detector signal occurs, the adjusted state of said scanning and holding circuit remaining until the following detector signal occurs.

2. A device as claimed in claim 1, characterized in that said auxiliary equalizing circuit (32) is impinged by a periodically varying adjusting signal by way of a sweep means (34), and that said primary equalizing circuit (12) is impinged by the output signal of said scanning and holding means (48).

3. A device as claimed in claim 2, characterized in that said detector includes a full wave rectifier (36) which is connected via a gate circuit (38) to an integrator (42) and to an extreme value detector (44) connected in series to said integrator, said gate circuit switching through during a detection window (x) which is symmetrical with respect to the zero passage of the undistorted input signal, and said extreme value detector emitting the detector signal (4.7) when the output signal of said integrator achieves a minimum during a period of the adjusting signal.

4. A device as claimed in claim 3, characterized in that the output of said auxiliary equalizing circuit (32) is connected to a synchronous means (18) generating an auxiliary signal pulse which has a predetermined phase relationship to the zero passages of the input signal, and that a signal delay circuit (401) is connected to the output of said synchronous means, and a switching amplifier (404; 404) controlling said gate circuit (38) and being hysteresis-loaded via a differentiator (402) is connected to the output of said signal delay circuit.

5. A device as claimed in any of claims 3 or 4, characterized in that said extreme value detector (44) includes a hysteresis-loaded difference amplifier (442), the two inputs of said difference amplifier each being connected to a signal input via a diode (D₁; D₂), the one input (−) of said difference amplifier being further connected to a delay circuit (443), the time constant of said delay circuit being great in relation to the period of said sweep means (34).

6. A device as claimed in any of the foregoing claims, characterized in that said equalizing circuits (12; 32) include a coarse area selector which is switchable manually or automatically in dependency from the input signal.

## Revendications

1. Dispositif d'une installation de transmission de signaux ou de données, pour le réglage d'un circuit de correction (12) raccordé à une voie de transmission, dont le signal de sortie possède une caractéristique déterminée détectable au moyen d'un détecteur (36 à 44) pour un réglage optimal variable, le détecteur (36 à 44) transmettant un signal de détecteur à un circuit ayant des capacités de mémoire, lorsque le signal de sortie possède la caractéristique déterminée, caractérisé en ce qu'il est prévu un circuit de correction auxiliaire (32) dont le signal de sortie commande le détecteur (36 à 44), que les deux circuits de correction (12, 32) sont alimentés en parallèle par un même signal déformé dans la voie de transmission, que le réglage du circuit de correction auxiliaire (32) peut être modifié périodiquement dans toute la plage de réglage, et qu'il est prévu un circuit d'exploraion et de maintien (48, 52), qui transmet le réglage instantané du circuit de correction auxiliaire (32) au circuit de correction principal (12) au moment de l'apparition du signal du détecteur, et dont le réglage est maintenu jusqu'au signal de détecteur suivant.

2. Dispositif selon revendication 1, caractérisé en ce que le circuit de correction auxiliaire (32) peut être commandé par un wobbulateur (34) au moyen d'un signal de réglage se modifiant périodiquement, et que le circuit de correction principal (12) peut être commandé par le signal du dispositif d'exploration et de maintien (48).

3. Dispositif selon revendication 2, caractérisé en ce que le détecteur comprend un redresseur en onde pleine (36), qui est raccordé par un circuit porte (38) à un intégrateur (42) et à un détecteur de valeur extrême (44), disposé après ce dernier, le circuit porte autorisant le passage pendant un intervalle de temps (x) symétrique par rapport au passage par zéro du signal d'entrée non déformé, et le détecteur de valeur extrême transmettant le signal du détecteur (4.7) lorsque le signal de sortie de l'intégrateur atteint un minimum pendant une période du signal de réglage.

4. Dispositif selon revendication 3, caractérisé en ce que la sortie du circuit de correction auxiliaire (32) est reliée à un dispositif de synchronisation (18) qui engendre un signal de cadence auxiliaire présentant un déphasage déterminé par rapport au passage par zéro du signal d'entrée et qu'un circuit de retard (401) est connectée à la sortie du dispositif de synchronisation, la sortie du circuit (401) étant connectée à un amplificateur de couplage (403, 404) présentant une hystérésis et commandant le circuit porte (38), par un circuit de différentiation (402).

5. Dispositif selon l'une des revendications 3 ou 4, caractérisé en ce que le détecteur de valeur extrême (44) comporte un amplificateur différenciateur (442) ayant une hystérésis et dont les deux entrées sont reliées chacune par une diode $(D_1, D_2)$ et à une entrée de signal, et dont une entrée (−) est de plus reliée à un circuit de retard (443) dont la constante de temps est grande par rapport à la période du wobbulateur (34).

6. Dispositif selon l'une quelconque des revendications précédentes, caractérisé en ce que les circuits de correction (12, 32) comportent un sélecteur de réglage grossier, dont le réglage peut être modifié manuellement ou automatiquement en fonction d'un signal d'entrée.

Fig. 1

Fig. 2

Fig. 3

Verstärker u. Bereichs- wähler

Fig. 4